# EUROPEAN PATENT APPLICATION

(11) **EP 3 627 428 A1**
(43) Date of publication of application: **25.03.2020**
(21) Application number: 19207299.9
(22) Date of filing: 21.02.2014
(51) Int. Cl.: G06Q 30/04, H04L 12/14, G06F 11/30, G06F 11/34, H04L 12/26, H04L 29/08, H05K 7/14, H04M 15/00, H04W 4/24

(54) **DATA FARM METERING**

(30) Priority: 21.02.2013 US 201313772853
(62) Divisional of application: 14754205.4
(71) Applicant: CFM Global LLC, Little Silver, NJ 07739 (US)
(72) Inventor: MACIOCH, Christopher P, Ocenport, New Jersey 07757 (US); PINGITORE, Michael, Aberdeen, New Jersey 07747 (US); PINGITORE, Frank C, Little Silver, New Jersey 07739 (US)
(74) Representative: Appleyard Lees IP LLP

(57) **Abstract**

Building support with a concealed electronic component for a structure, including: a rigid support member; a mounting attachment affixed to the rigid support member, the mounting attachment adapted to support an electronic component; and a transceiver coupled to the electronic component, the transceiver adapted to support an external communication link. Other embodiments provide a backing material to support an electronic component concealed within a building structural element, wherein the building structural element comprises one or more rigid building support members, the backing material including: a substrate; a structure attachment along at least one surface of the substrate, the attachment adapted to attach the substrate to a rigid building support member; and one or more electronic component attachments disposed on a major surface of the rigid substrate.

## Description

### BACKGROUND

### Cross-Reference to Related Applications

This application claims the benefit of U.S. Patent Application Ser. No. 13/772,853, filed on February 21, 2013, the entire content of which is hereby incorporated by reference in its entirety.

### Field of the Invention

Embodiments of the present invention generally relate to a concealed building support, and, in particular, to an apparatus, system and method for providing a concealed building support that is adapted to house or support an electronic component.

### Description of Related Art

It is well known that we are a data driven society. Over the past several years there has been a push to convert all of our society's global data, communications, media, etc into a digital format and store that information on physical media such as hard drives, CDs and DVDs. The amount of digital data that our society is creating is growing exponentially, and the corresponding need for data storage is growing exponentially. Everything from books, pictures, movies, television, personal files, business files, telephone conversations, and more, are being converted to a digital format and stored on physical media as digital data. Certain digital data may need to be archived for an extended period of time in order to satisfy recordkeeping laws, thereby further expanding the storage needs. Most new data is born into the digital world while all existing media is being converted. Digital data storage space has become both a resource and a commodity.

Digital data has traditionally been stored locally in a storage asset associated with a computer that generated the data, e.g., on the computer's hard drive, or stored onto magnetic, optical, and/or removable storage media such as CDs, DVDs, removable flash drives, floppy disks, and so forth. A single storage asset, or a small number of clustered storage assets, may consume a relatively modest amount of energy, and/or generate a modest amount of heat, and/or generate little attention or scrutiny from outsiders. Alternatively, the digital data may have traditionally been stored nearby, such as memory accessible to a server on a local area network ("LAN"). These storage solutions require that an end user or an administrator attend to the storage media by, e.g., replacing defective media such as a failed hard drive, securely storing removable media such as flash drives, CDs, DVDs, etc. when not in use, rebooting a client or server if either computer crashes or enters an unstable state, making regular backups to guard against data corruption or accidental erasure of data, and so forth.

Due to the inconvenience involved with maintaining local or nearby computer storage, and the resultant probabilities of data loss if the computers or storage media are not properly maintained, a trend has developed in recent years to migrate storage to "the Cloud," which can then be remotely accessed from devices such as computers, laptops, tablets and phones. Data storage in the Cloud requires fast communication access to a remotely-located storage system. Communication access is typically through the Internet, using Ethernet and TCP/IP. Other protocols may be used depending upon the data, such as real-time transport control protocol ("RTCP") as known in the art for streaming media.

Cloud-based storage shifts the burden of maintaining data storage assets to a central manager, e.g., a conventional data warehouse and warehouse operator. Cloud-based storage typically requires a relatively large number of storage assets. Economies of scale may be achieved for some aspects of operation, such as having dedicated technical support available in order to tend to hardware failures, enforce security or backup policies, and so forth.

However, a concentration of storage assets in a data warehouse may create problems that exceed a tolerable level unless mitigated. For example, an N-fold increase in the number of storage assets may by themselves cause an N-fold increase in power consumption and heat generation, which in turn requires higher-capacity climate control equipment and concomitant further increases in energy consumption for cooling. Modern data warehouses have become massive facilities that consume large amounts of power, large plots of lands, and require high-capacity communication trunks to support the data traffic.

Furthermore, the conventional data warehouse draws attention to itself due to its physical size, the value of the data stored within it, and the threat of business disruption if the data warehouse were to be attacked or otherwise suffer a failure. Conventional wisdom teaches away from a disfavored maxim known as "security through obscurity," which holds that sufficient security of an asset may be achieved by attempting to hide the asset without the need for overwhelming security protection. Thus the data warehouse requires increased physical security in order to guard against criminals, terrorists and similar threats.

The required infrastructure of a conventional data warehouse, i.e., to supply the electrical energy, to supply cooling capacity, to supply communication network capacity, and to supply physical security, increases the cost and eco-footprint of operating a data warehouse and may not be appealing to eco-conscious consumers or consumers who seek a lower cost to store data in the Cloud.

Therefore, a need exists to provide a Cloud-based storage system that is less resource-intensive to operate than a traditional data warehouse, in order to provide a lower-cost and/or more eco-friendly storage system for customers, and ultimately improved customer satisfaction.

### SUMMARY

Embodiments in accordance with the present invention avoid the drawbacks of the known art by providing a dispersed, distributed file system in order to host Cloud-based storage. Storage nodes, which may be individual hard drives or clusters of co-located hard drives, may be dispersed and located within buildings that are not ordinarily used for data warehouses, such as ordinary homes, office buildings, retail locations, and so forth.

Storage nodes may be located within unobtrusive but otherwise unused space of the buildings, such as (in the case of an ordinary home) structural space and/or open interior space that is enclosed by the structure. Open interior space may include attic space, basement space, and so forth. Structural space may include space within the structure itself, such as space within walls, space under floorboards, and so forth. Structural space is often closed off with limited physical access compared to open interior space. The dispersed, redundant, fault-tolerant and unobtrusive nature of the storage nodes reduces the need for electrical power, environmental control, communication speeds, and elaborate security measures.

Building owners are encouraged to host storage nodes in their properties and participate in ongoing operation of a storage network, by receiving fees or other monetary incentives (e.g., royalty checks, discount coupons from local merchants, etc.), or non-monetary incentives (e.g., preferred memberships in a business such as a local gym, charitable donations in their name, etc.).

Embodiments in accordance with the present invention may be marketed to data farmers and Primary Source Data Clients as a "green" (i.e., eco-friendly) product. Compared to large data centers, embodiments use substantially less electricity. Conventional data storage centers typically use hard drive storage, which use spinning motorized drives that are constantly powered. In contrast, embodiments may utilize solid state technologies for reduced power consumption and reduced heat production required for storage. With the use of more efficient technology and the dispersal of individual storage assets, large data centers will not be required. The elimination of these centers would in turn eliminate the need for large heating, ventilation and air conditioning ("HVAC") equipment and their resultant large power demands.

Embodiments in accordance with the present invention may provide a system and method for distributed file storage, the system including: a plurality of data farms, each data farm including: a data storage module; a local control module comprising a data protection module; and a communication interface between said data farm and a wide-area network; an interface to one or more remote data applications; and an administrative module configured to record a quantity of data received or transmitted by the communication interface of the data farm. The method may include: providing a plurality of data farms; accepting data from a remote data application; selecting a data farm from among the plurality of data farms in which to store the data; and storing the data in the selected data farm.

Embodiments in accordance with the present invention may provide a building support with a concealed electronic component for a structure, including: a rigid support member; a mounting attachment affixed to the rigid support member, the mounting attachment adapted to support an electronic component; and a transceiver coupled to the electronic component, the transceiver adapted to support an external communication link.

Embodiments in accordance with the present invention may provide a backing material to support an electronic component concealed within a building structural element, wherein the building structural element comprises one or more rigid building support members, the backing material including: a substrate; a structure attachment along at least one surface of the substrate, the attachment adapted to attach the substrate to a rigid building support member; and one or more electronic component attachments disposed on a major surface of the rigid substrate.

The preceding is a simplified summary of embodiments of the disclosure to provide an understanding of some aspects of the disclosure. This summary is neither an extensive nor exhaustive overview of the disclosure and its various embodiments. It is intended neither to identify key or critical elements of the disclosure nor to delineate the scope of the disclosure but to present selected concepts of the disclosure in a simplified form as an introduction to the more detailed description presented below. As will be appreciated, other embodiments of the disclosure are possible utilizing, alone or in combination, one or more of the features set forth above or described in detail below.

### BRIEF DESCRIPTION OF THE DRAWINGS

The above and still further features and advantages of the present invention will become apparent upon consideration of the following detailed description of embodiments thereof, especially when taken in conjunction with the accompanying drawings wherein like reference numerals in the various figures are utilized to designate like components, and wherein:
FIG. 1 is a block diagram depicting a distributed file system in accordance with an embodiment of the present invention;
FIG. 2 illustrates at a high level of abstraction a server of a distributed file system, in accordance with an embodiment of the present invention;
FIG. 3 illustrates an exemplary structural storage location, in accordance with an embodiment of the present invention;
FIG. 4 illustrates a housing for a storage apparatus, in accordance with an embodiment of the present invention; and
FIG. 5 illustrates a cross sectional view of a plurality of housings deployed at a data farm, in accordance with an embodiment of the present invention.

The headings used herein are for organizational purposes only and are not meant to be used to limit the scope of the description or the claims. As used throughout this application, the word "may" is used in a permissive sense (i.e., meaning having the potential to), rather than the mandatory sense (*i.e*., meaning must). Similarly, the words "include", "including", and "includes" mean including but not limited to. To facilitate understanding, like reference numerals have been used, where possible, to designate like elements common to the figures. Optional portions of the figures may be illustrated using dashed or dotted lines, unless the context of usage indicates otherwise.

### DETAILED DESCRIPTION

The disclosure will be illustrated below in conjunction with an exemplary communication system. Although well suited for use with, e.g., a system using a server(s) and/or database(s), the disclosure is not limited to use with any particular type of communication system or configuration of system elements. Those skilled in the art will recognize that the disclosed techniques may be used in any communication application in which it is desirable to utilize a low-cost and low-overhead distributed file system.

The exemplary systems and methods of this disclosure will also be described in relation to software, modules, and associated hardware. However, to avoid unnecessarily obscuring the present disclosure, the following description omits well-known structures, components and devices that may be shown in block diagram form, are well known, or are otherwise summarized.

In the following detailed description, numerous specific details are set forth in order to provide a thorough understanding of embodiments or other examples described herein. In some instances, well-known methods, procedures, components and circuits have not been described in detail, so as to not obscure the following description. Further, the examples disclosed are for exemplary purposes only and other examples may be employed in lieu of, or in combination with, the examples disclosed. It should also be noted the examples presented herein should not be construed as limiting of the scope of embodiments of the present invention, as other equally effective examples are possible and likely.

As used herein, the term "module" refers generally to a logical sequence or association of steps, processes or components. For example, a software module may comprise a set of associated routines or subroutines within a computer program. Alternatively, a module may comprise a substantially self-contained hardware device. A module may also comprise a logical set of processes irrespective of any software or hardware implementation.

The term "computer-readable medium" as used herein refers to any tangible storage and/or transmission medium that participates in storing and/or providing instructions to a processor for execution. Such a medium may take many forms, including but not limited to, non-volatile media, volatile media, and transmission media. Non-volatile media includes, for example, NVRAM, or magnetic or optical disks. Volatile media includes dynamic memory, such as main memory. Common forms of computer-readable media include, for example, a floppy disk, a flexible disk, hard disk, magnetic tape, or any other magnetic medium, magneto-optical medium, a CD-ROM, any other optical medium, punch cards, paper tape, any other physical medium with patterns of holes, RAM, PROM, EPROM, FLASH-EPROM, solid state medium like a memory card, any other memory chip or cartridge, a carrier wave as described hereinafter, or any other medium from which a computer can read. Computer-readable medium may also include volatile or non-volatile emerging storage media such as data encoded in chemical or organic-chemical cells, and holographic cells. A digital file attachment to e-mail or other self-contained information archive or set of archives is considered a distribution medium equivalent to a tangible storage medium. When the computer-readable media is configured as a database, it is to be understood that the database may be any type of database, such as relational, hierarchical, object-oriented, and/or the like. Accordingly, the disclosure is considered to include a tangible storage medium or distribution medium and prior art-recognized equivalents and successor media, in which the software implementations of the present disclosure are stored.

Embodiments in accordance with the present invention provide a system for data storage and backup that will utilize existing underutilized or "wasted" spaces, voids, etc. inside industrial, commercial and residential buildings in order to generate a new source of data storage space and create a symbiotic data storage relationship between big corporations, small business, homeowners, and data servicers.

The data farms hosts may receive income for storing the data within their structures. They may provide a dedicated high-speed internet connection for the storage system, thus allowing fast access and download of backup information as well as the retrieval of documentation at any time.

Embodiments in accordance with the present invention will provide to data generators and data users (e.g., corporate data users) an alternate physical location to store their digital data and backups. These new digital storage locales will provide to their users an offer of multiple backups around the world. This will further protect corporations' backups from natural disasters or attacks, both physical and cyber.

The data storage devices will be installed in "empty" spaces or "voids" in industrial, residential and commercial structures. Such hidden, discreet or unobtrusive locations may include, but are not limited to, cavities inside the wall space, attic space, heating ventilation and air conditioning ("HVAC") ducts, conduit, etc. Typically the data storage devices may include solid state storage units within a protective enclosure, which are then installed in discreet locations. If the data storage device is installed within an exterior wall or other boundary with an area that is not temperature-controlled, the device sheathing or housing will tend to reduce such variations. The storage devices may also be incorporated into a number of construction materials to utilize the mass of the structure for data storage. For example, along the side of a steel I-beam and/or steel stud, along the surface of metal paneling, or voids that may be pre-formed into concrete slabs, planks, studs, etc., and so forth, i.e., substantially any place that a void exists (either natural or planned). Existing structures could be retrofitted and new construction could use the building materials prefabricated with data storage devices. The data storage units may be interconnected and gridded for optimal flow of data and storage throughout the structure while consuming less energy than traditional storage facilities.

The data sent and stored to these data storage devices would be managed and maintained by a third party data servicing company. The third party providers would coordinate backups between corporations seeking backup security and the "housers" of the storage units (i.e., the data farmer). Charges may be based on the size of the system and the frequency in which information is retrieved for restore purposes. Charges may also be based on how much data is transferred to or from the "housers" on a daily basis.

Data security is an important consideration related to the transfer and storage of the data. The data may be encrypted by a third-party provided so if an unauthorized entity attempts to access data stored in a data farm, the unauthorized entity would not be able to decipher the data. Access by proxy may be allowed, wherein a user or process may access the data in a data farm on behalf of a end user, decrypt or otherwise process the retrieved data, then send the processed data to the end user. Improved security is provided at data farms by limiting knowledge at data farms of their existence and operation only to persons having a need-to-know at the data farm. A data farmer will not know whose information is being routed through their storage devices, nor will the end-client know precisely at what locations or which data farms their information is stored. This provides the invention's security through obscurity.

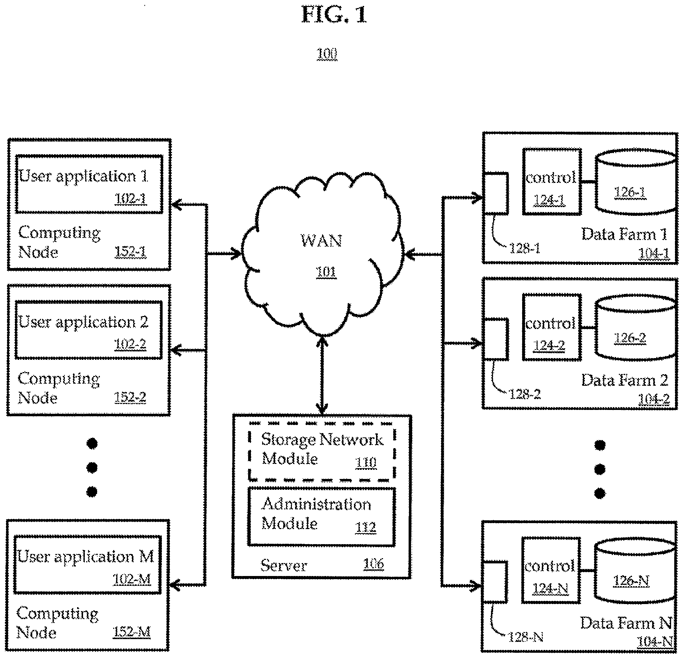

FIG. 1 illustrates at a high level of abstraction a system 100 in accordance with an embodiment of the invention. System 100 includes a plurality of computing nodes 152-1 ... 152-M hosting one or more user applications 102-1 ... 102-M, a plurality of data farms 104-1 ... 104-N, and a server 106, interconnected as shown through a wide area network ("WAN") 101 such as the Internet. An individual but unspecific user application may be referred to herein as user application 102-m or as user application 102. An individual but unspecific data farm may be referred to herein as data farm 104-m or as data farm 104. An individual but unspecific computing node may be referred to herein as computing node 152-m or as computing node 152. Computing note 152 may include a server coupled to a memory and associated internal and/or external communication interfaces in order to support user application 102.

Server 106 may be a software-controlled system including a processing unit (CPU), microprocessor, or other type of digital data processor executing software or an Application-Specific Integrated Circuit (ASIC) as well as various portions or combinations of such elements. Server 106 may further include a storage network module 110 and/or an administrative module 112.

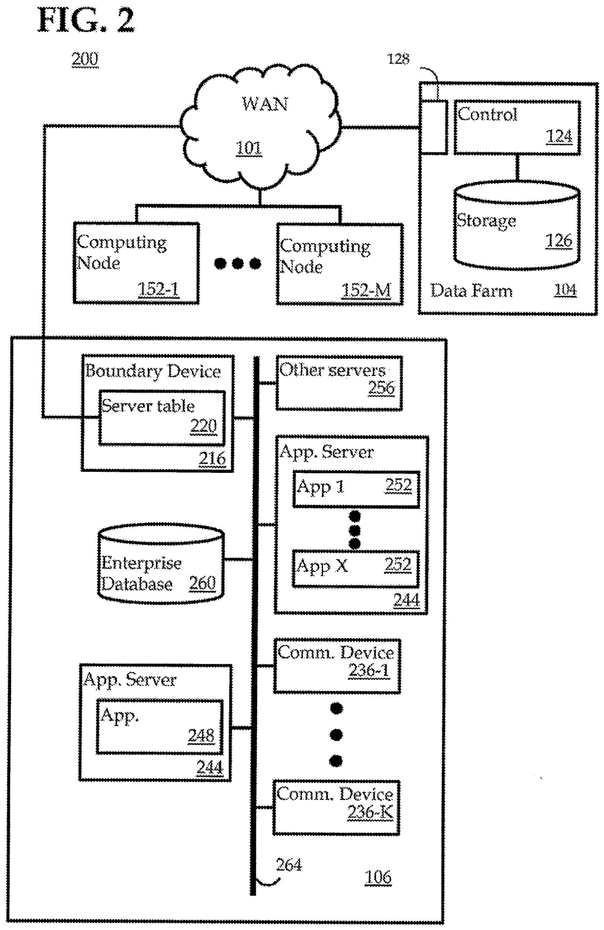

FIG. 2 depicts a distributed file system ("DFS") 200 according to an embodiment of the present disclosure, with an emphasis on depicting exemplary components of server 106 at a lower level of abstraction. DFS 200 may include a server 106 that is in communication, via a (typically untrusted or unsecure or public) WAN 101, with one or more external computing nodes 152. The external computing nodes 152 are not under the direct control of the enterprise administering the server 106 and/or have a decreased level of trust with the server 106 as compared with communication devices 236-1 ... 236-K that are within the server 106. Communication devices 236-1 ... 236-K may include a local terminal or similar interface to provide direct, local control of server 106. Exemplary types of external computing nodes 152 include, without limitation, laptops, Personal Computers (PCs), Personal Digital Assistants (PDAs), gateways to other LANs or WANs, and the like.

The server 106 may include a boundary device 216 including a server table 220, one or more internal communication devices 236-1 ... 236-K, one or more application servers 244 which may be capable of providing one application 248 or a set of different applications 252, a number of other servers 256 to provide other functions of server 106, and an enterprise database 260, all of which are interconnected by a (trusted or secure or private) Local Area Network (LAN) 264. Some or all of the functions depicted in FIG. 2 may be co-hosted and/or co-resident on a single server. The depiction of components in FIG. 2 is generally intended to be a logical depiction of the components of the system 200.

The LAN 264 can be secured from intrusion by untrusted parties by a gateway and/or firewall located between the LAN 264 and WAN 101. In some embodiments the boundary device 216 may include the functionality of the gateway and/or firewall. In some embodiments, a separate gateway or firewall may be provided between the boundary device 216 and WAN 101.

In some embodiments, network boundary device 216 is responsible for initially routing communications within the server 106 for servicing a particular user involved in accessing the DFS. Communications server 244 with enterprise database 260 may perform the functions of storage network module 110.

Although only two application servers 244 are depicted, one skilled in the art will appreciate the one, two, three, or more applications servers 244 can be provided and each server may be configured to provide one or more applications. The applications provided by a particular application server 244 may vary depending upon the capabilities of the server 244 and in the event that a particular application server 244 comprises a set of applications 252, one, some, or all of the applications in that set of applications 252 may be included in a particular application sequence. Application server 244 may be used to perform the functions of administration module 112.

Referring again to FIG. 1, each data farm 104-n may include a storage apparatus 126 and a local control module 124. Storage apparatus 126 may include substantially any type of computer-readable medium. Local control module 124 provides a communication interface between WAN 101 and storage apparatus 126. Local control module 124 may further provide firewall, gateway, routing functions, administrative and local processing control of its associated data farm 104. Local control module 124 acts as a server for its associated data farm 104.

At least some of data farms 104-n may differ from one another based upon factors such as the type of storage technology used for storage apparatus 126, its associated latency, and the speed and/or latency of its associated communication link to WAN 101. Similarly, at least some of computing nodes 152-m may differ from one another at least in computing throughput and in the speed and/or latency of its associated communication link to WAN 101. Therefore, system 100 may be able to accommodate a heterogeneous and geographically diverse network environment, unlike some systems of the known art in which each of data farm 104-n may represent, e.g., a rack of storage units in a conventional data farm. System 100 may be useful for storage applications in which relatively higher latencies and tolerances may be tolerable, such as for a storage application that is used to infrequently access data stored for archival backup purposes.

In some embodiments, a portion of memory associated with computing node 152 may be usable as part of a data farm 104 for a different computing node 152.

The plurality of data farms 104 together provide a distributed file system used by one or more of user applications 102. User applications 102 write data to the DFS and/or read data from the DFS, and are thus data users. The DFS optionally operates under the control of server 106, and in particular under the control of storage network module 110. The DFS is designed to store very large data sets reliably, and to stream those data sets to user applications 102. A large DFS may include thousands of data farms 104. By distributing storage and local processing control across many servers, the DFS may grow with demand while remaining economical at substantially every size.

One protocol for providing a distributed file system is Hadoop, which provides a framework for an analysis and transformation of very large data sets using a MapReduce paradigm. Under Hadoop, data and computation may be partitioned across thousands of data farms 104. A Hadoop-based DFS may scale storage capacity and I/O bandwidth by simply adding additional data farms 104.

Server 106 may implement Hadoop NameNode functions, and data farms 104 may implement DataNode functions. Under Hadoop, the NameNode is important to the operation of the DFS. The NameNode keeps a directory tree of all files in the file system, and tracks where across the cluster the file data is kept. The NameNode does not store the data of these files itself.

User applications 102 communicate with the NameNode whenever the user application 102 attempts to locate a file in the DFS, or when the user application 102 attempts to add/copy/move/delete a file in the DFS. The NameNode responds the successful requests by returning a list of relevant DataNode servers where the data is stored.

The NameNode should be a highly reliable computing element, since if the NameNode fails then the DFS will go offline. An optional secondary NameNode may be used to provide protection if a primary NameNode fails. The NameNode should be hosted on a server having a large amount of RAM space.

Under Hadoop, the DFS stores data in DataNodes. The DFS has numerous DataNodes, and data may be replicated across more than one DataNode. On startup, a DataNode connects to the NameNode and is then ready to support DFS operations.

User applications 102 may communicate directly to a DataNode after the NameNode has provided the location of the data. DataNodes may communicate with each other, such as if they are replicating data. There is usually no need to use RAID storage for DataNode data, because data is designed to be replicated across multiple data farms 104, rather than multiple disks on the same data farm 104.

The distributed file system may be based on other protocols known in the art, such as BitTorrent, PVFS, or Lustre. For example, Lustre is known as a storage-architecture for data clusters. The central component is the Lustre file system, a shared file system for clusters. The Lustre file system is currently available for Linux and provides a POSIX-compliant UNIX file system interface. Storage network module 110 may not be needed if a peer-to-peer protocol such as BitTorrent is used.

Each farm of data farms 104 may have characteristics such as capacity, underlying storage technology, storage latency, communication latency, local controller capabilities, etc., that are independent of similar characteristics at other farms of data farms 104. These characteristics may vary significantly from one data farm 104 to another. In this way, the DFS is operable with a heterogeneous collection of data farms.

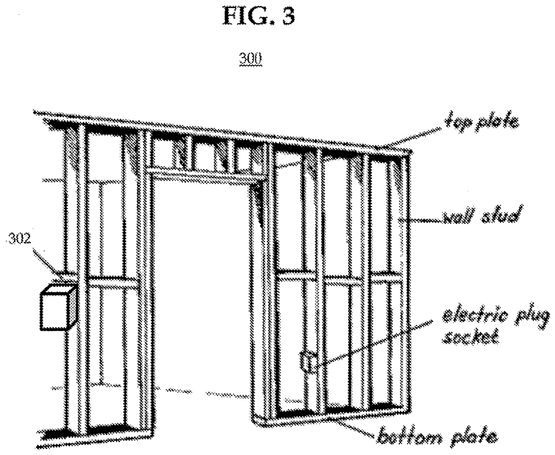

Each of data farms 104 may be located in widely dispersed locations, such as in discreet and unobtrusive locations in structures located substantially anywhere nationwide or worldwide, so long as it is reachable through WAN 101. A structure such as a house typically has hidden spaces that are physically large enough to install a computer-readable medium. Such computer-readable medium could be installed during construction or retrofitted later, for use as a data farm 104-m. For example, FIG. 3 illustrates an internal view of a wall 300 without attached drywall. The wall typically includes a horizontal top plate, a horizontal bottom plate, and a plurality of vertical wall studs. The wall usually includes wiring as part of the electrical system, and sometimes also includes separate wiring for an Ethernet network. Access to the electrical system external to the wall may be provided by an electric plug socket.

Other discreet and unobtrusive locations within a typical house include within or between floor joists, basement areas, attic areas, under a stairway, hollow core doors, etc. Within an office building, other discreet and unobtrusive locations may be available, such as under a raised floorboard, above a false ceiling, within modular walls, and so forth.

The discreet and unobtrusive locations should be physically large enough to accommodate a storage apparatus 126 (or a cluster of storage apparatus 126) and associated local control 124, typically within a support and protective enclosure. For example, a low-latency storage apparatus 126 may include a portable disk drive or a solid state drive, which are commonly available in sizes such as approximately 3" x 4" x 1". A high-latency storage apparatus 126 may include a USB flash drive, which are commonly available in sizes such as approximately 2" x 0.75" x 0.4". A tablet-based local controller 124 may be approximately 7" x 4" x 1". In some embodiments the local controller 124 may include communication interface 128. Deployment of systems in accordance with an embodiment of the present invention will be able to adapt to new structure materials and building methods, e.g., writing of data to the surface of wall panels.

Other locations may be used as a data farm 104, so long as there is access to electrical power and communication services as may be required. For example, data farm 104 may be placed outside such as on a rooftop, atop a telephone pole, or incorporated into renewable energy systems (e.g. solar panels, wind turbines, etc.). Such locations may also rely upon renewable power (e.g., solar panels, wind turbine, etc.) with battery backup for electrical power, and WiFi signals (either public or as provided by a data farmer) for a communication link. Space in other structures such as garages and sheds may also be used. Structural materials (e.g., studs) may be pre-configured to include storage modules. Such pre-configured structural materials may be suited if retrofitting a structure to include embodiments in accordance with the present invention, with minimal impact to other aspects of usage of the structure. Outdoor locations and other uncontrolled environments may require local controllers 124 and storage apparatus 126 that are ruggedized for the expected temperature swings and protected against wind, rain, and other elements.

A higher-latency storage apparatus 126 may include one or more USB flash drives. Flash drives are commonly available in capacities ranging from 2 GB to 64 GB and higher. For example, a controller such as an Android tablet or similar compact computing device may include a USB port. The USB port may be further fanned-out by use of one or more USB hubs. Flash drives may then be connected to one or more of the USB ports. Usage of flash drives for the storage apparatus has an added benefit of typically consuming less power than usage of a portable disk drive.

In a further embodiment, individual storage units having an appropriate USB ports may be daisy-chained together, in order to provide a composite storage apparatus 126 having more data storage capacity than an individual storage unit.

In a further embodiment, a data farm 104 may include an expandable data bus. Individual storage units may be added to data farm 104 by connecting the additional storage unit to the data bus. Expandability of an individual data farm 104 may also be achieved by usage of wireless communication methods, which may be inherently expandable. Wireless methods may include WiFi (IEEE 802.11) and short-range communication such as Bluetooth (IEEE 802.15.1), Zigbee (IEEE 802.15.4), etc.

All storage apparatus 126 and associated local control units 124 at data farm 104 should be substantially concealed. A person should not be aware that they were within a data farm 104. Data farm 104 may be used as primary data storage or as backup data storage for remote clients. Higher latency storage devices may be more useful for backup storage applications.

Referring again to FIG. 3, a storage enclosure 302 may be located within the wall 300. Storage enclosure includes the components of data farm 104. Physical characteristics of storage enclosure 302 may be adapted to the specific installation location. For example, the size, shape, capacity, etc. of storage enclosure 302, and the mounting or support it provides to components of data farm 104, may be adapted to the available space. Storage enclosure 302 may not be fully enclosed, e.g., a top direction may be left open for ease of maintenance and because ordinarily for mounting locations within a wall there is little risk of unwanted physical intrusion from the top. Enclosure requirements (e.g., the degree of enclosure, which directions may be relatively exposed, the strength of the enclosure, etc.) may vary from one installation site to another, based on factors such as the installation location and the method of securing the enclosure and/or data farm.

Once drywall is attached to the wall studs, the storage enclosure 302 will be hidden from view. Electrical power may be supplied to storage enclosure 302 by tapping into electrical wiring that is already present within the wall. Alternatively, electrical power may be supplied by discreetly routing power supply wires through walls, floors, etc. to the location of storage enclosure 302. Data farms 104 having sufficiently low-power electrical power consumption may be powered by wireless methods and systems such as inductive power coupling. An inductive power system includes a transmitter coil and a receiver coil. Both coils form a system of magnetically coupled inductors. An alternating current in the transmitter coil generates a magnetic field which induces a voltage in the receiver coil. This voltage can be used to power a sufficiently low-power data farm 104. The transmitting coil may be located on the room-facing side of a drywall wall, and the receiving coil on the interior-facing side of the drywall wall. One portion of a data farm (e.g., a controller or hub) may be configured to receive power from an outside source, and other components (e.g., USB devices) may be configured to receive any necessary power from the controller or hub through a USB link (or other communication link).

Similarly, data farm 104 should include a communication interface 128 to WAN 101. The communication link may include one or more embodiments such as: an Ethernet interface to a broadband access point (e.g., a hub and/or router); a wireless interface (e.g., WiFi) to a host-supplied broadband access point (e.g., a wireless router); a WiFi interface to a public WiFi hotspot; a 4G wireless cell phone interface to a cell phone communication tower; USB link; a fiber optic link; a wireless (free-space) optic link; laser, and so forth. Power may be conserved by placing the data farm 104 in a receive-only or listen-only mode, until the data farm 104 needs to respond (e.g., providing data, responding to a ping, etc.).

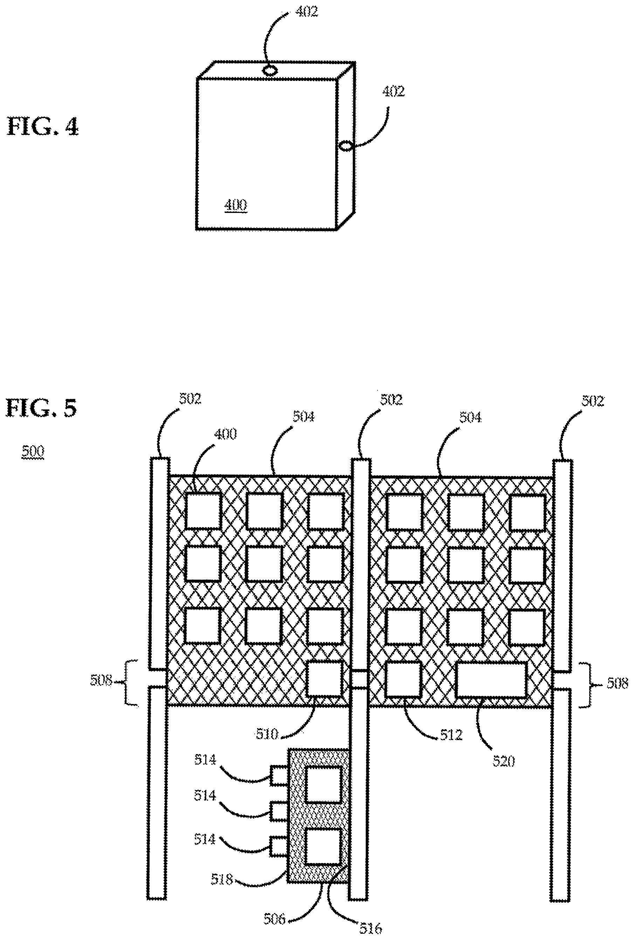

FIG. 4 illustrates a housing 400 for a storage apparatus 126 in accordance with an embodiment of the present invention. Although housing 400 is illustrated as a parallelepiped with six surfaces (including two major surfaces and four edge surfaces), the shape of housing 400 is not constrained to such a shape. Alternative shapes having other numbers of surfaces may be used, such as more surfaces (e.g., a geodesic shape, solid hexagon, etc.) or fewer surfaces (e.g., sphere, cone, pyramid, etc.). Furthermore, housing 400 need not fully enclose a space. For example, housing 400 may include one open side. Alternatively, housing 400 may include only one surface, configured to mount storage apparatus to one side of the mounting surface, and the mounting surface being attached on its other side to a rigid base.

Housing 400 may include one or more transceivers 402 configured to communicate in at least a 90 degree angle around housing 400. Preferably, multiple transceivers 402 are used to provide 360-degree communication in a plane surrounding housing 402. Alternatively, multiple transceivers 402 may be used to provide spherical or hemispherical coverage around housing 402. FIG. 4 illustrates transceivers 402 located on two of the three visible planar surfaces of housing 400. Transceivers 402 may be located at substantially any exterior points of housing 400, including a surface, and edge, and/or a corner. Alternatively, transceivers 402 may be mounted internally to housing 402, either behind a surface of housing 400 that is transparent to the wireless signal (e.g., a glass window for optical signals), or configured to transmit through an open side of housing 400.

Transceivers 402 may be used to communicate wirelessly with storage apparatus 126 within housing 400. Communication may including: sending and/or receiving data to be stored in, or retrieved from, storage apparatus 126; controlling storage apparatus 126; and/or transmitting status of storage apparatus 126. Transceivers 402 may use substantially any wireless communication technology, such as RF (e.g., WiFi, ZigBee, Bluetooth, etc.), infrared, optical (e.g., LED or laser); ultrasound, etc.

Within housing 400 there may be included a securing apparatus to securely attach storage apparatus 126 to housing 400. Securing apparatus may include screws, bolts, adhesive, tie-straps, and so forth. Housing 400 may further include a controller configured to read/write data to/from the storage apparatus 126. The controller may be further configured to provide a communication interface via transceivers 402. The controller may be further configured to provide a status or state of health via transceivers 402, either periodically or in response to a query.

FIG. 5 illustrates a cross-sectional view 500 of a plurality of housing 400 installed within a wall, in accordance with an embodiment of the present invention. View 500 illustrates three wall studs 502, but persons of skill in the art will understand how to extend view 500 to more than three studs. Between a pair of adjacent studs 502 may be deployed a plurality of housings 400. An individual housing 400 may be in communicative contact with at least one neighboring housing 400. A backing material 504 may be provided, upon which at least some of the plurality of housings 400 may be mounted. Backing material 504 may be a mesh, webbing, solid board, combination thereof, and so forth, that is sufficiently strong in order to maintain the positions of housings 400 relative to one another, so that communications with a neighboring housing 400 via transceivers 402 may be supported. Backing material 504 allows for a plurality of housings 400 to be installed in advance on backing material 504 (e.g., at a factory), then attaching the backing material populated with housings 400 to studs 502. Backing material 504 may be large enough to be secured on opposite sides to studs 502 that are separated by a standard distance as known in the building construction arts.

Communication between different sides of a stud 502 may be facilitated by an aperture 508 within stud 502. Aperture 508 may allow for housings 400 on opposite sides of stud 502 to communicate with one another. For example, housing 510 and housing 512, on opposite sides of the center stud 502 of FIG. 5, may be in communicative contact with each another. The communicative contact may be by wired or wireless methods.

In another embodiment in accordance with the present invention, a backing material 506 may be provided that is attached on at least one side 516 to a secure object such as stud 502, and having at least one other side 518 that is configured to be expandable. Although side 518 is illustrated opposite of side 516, side may be positioned substantially anywhere along a perimeter or major surface of backing 506, or portion thereof, so long as the attachment of side 516 to a secure object is not impaired. Side 518 may include a locking apparatus 514 (e.g., interlocking protrusions) that are configured to interlock with matching voids of an expansion board (not shown in FIG. 5), thereby providing expandability. The expansion board may be substantially similar to backing 506.

The plurality of housings 400 may be in communicative contact with a controller 520, which in turn is communicatively connected to WAN 101. The plurality of housings 400 may communicate by use of protocols known in the art of data networking, such as a flood protocol.

In some embodiments, housings 400 may be able to report on a state of health or state of failure of storage apparatus 126 within the respective housing 400, along with an identifier of the housing 400 reporting the health or failure. In such embodiments, at least in part because of a relatively fixed spatial relationship provided by attaching housings 400 to backing material 504 or 506, a failure map may be generated and made available to maintenance personnel. The failure map may provide a graphical depiction of a specific housing 400 that is reporting a failure (or lack of reporting of good health). The failure map may facilitate repairs by identifying failed storage apparatus 126 for quick replacement.

Conventional data warehouses are housed within a trusted data and computing environment, such that strong data security measures against malicious attack is unnecessary for communications within the environment. In contrast, embodiments in accordance with the present invention include data farms located in widely dispersed locations, which are typically interconnected through an untrusted WAN 101 such as the Internet. Therefore, each dispersed data farm 104 should include a data protection module such as a firewall, anti-virus processes, and so forth. Data protection modules may be implemented in local controller 124 and/or communication interface 128. Each data farm 104 includes a trusted environment behind its respective data protection module but, as among separate and different data farms 104, the separate data farms 104 are in an untrusted data relationship.

In some embodiments in accordance with the present invention, the plurality of housings 400 may be mounted on a visible surface, rather than inside a wall. For example, a plurality of housings 400 may be attached to a visible surface of a wall in order to provide an artistic display. The plurality of housings 400 may be secured to the wall by conventional apparatus such as screws, bolt, clamps, welds, adhesive, Velcro, and so forth.

For distributed file systems that employ a central administrative node (e.g., a DFS based on Hadoop or similar), storage network module 110 may attend to control aspects of operating the DFS, and administrative module 112 may attend to billing and credit aspects of operating the DFS.

For distributed file systems that do not employ a central administrative node (e.g., a DFS based on BitTorrent or similar), individual local controllers 124-n in associated data farms 104-n, in cooperation with controllers and storage in computing nodes 152-m, may attend to control aspects of operating the DFS, and to monitoring of data bandwidth usage through the associated node 152-m or data farm 104-n for billing and administrative purposes. Usage data so collected may be reported to administrative module 112, which may then attend to billing and credit (i.e., compensation) aspects of operating the DFS.

Communication service and/or electrical power to data farm 104 may be disrupted at certain times. For example, downed trees may cause disruption to electrical or Internet connectivity, or a homeowner may perform renovation work that unwittingly affects the data farm hardware, or a homeowner may change broadband communication service providers, or may decide to let such service lapse (such as if moving), or the service may be disconnected, and so forth. Many such scenarios are possible. Consequently, system operation of the DFS should be resilient to failure or disconnection of individual data farms 104 from the network. Techniques to ensure resiliency are known in the art and include data replication, data striping, RAID storage, error correction codes, etc.

In one embodiment, system resiliency may be achieved by replicating multiple copies of data throughout the DFS, such that each data item is stored on two or more data farms 104. A system controller such as storage network module 110 may monitor a state of health of one or more data farms. Monitoring may be useful to determine utilization of the data farm, whether the data farm is online or offline, error conditions, and so forth. Monitoring a data farm may include periodically ping each data farm 104 to determine if it is still functional. Alternatively, each data farm 104 may be configured to provide a periodic heartbeat signal to the system controller. The heartbeat may include status information. The system controller may keep track of whether each data farm 104 is online or offline. If an individual data farm becomes offline, the system controller may then replicate the data items that had been stored on the offline data farm 104, by contacting the functioning data farms 104 that are storing copies of the data items. Copies of the data items may they be stored on one or more additional data farms 104, either by first sending the data items to system controlled 110 for redistribution, or by sending the data items directly to the selected data farms 104.

Embodiments in accordance with the present invention include a method of operating a DFS such that property owners are compensated for housing a data farm 104, and users of computing nodes 152-m obtain the benefit of a secure and resilient DFS at a lower overall cost than from a traditional highly secure data farm.

A method of operating the DFS may involve actions by entities such as: a user of a computing node 152-m (referred to herein as a "Primary Source Data Client"); a property owner associated with data farm 104-n (referred to herein as a "data farmer"); and a network operator associated with administration module 112 (referred to herein as a "data utility" or "data utility company").

A Primary Source Data Client may be billed on the amount of system resources used, e.g., on the number of megabytes of data written to and/or read from the DFS, or based upon an amount of memory space used by the client, and so forth. This pricing model may be useful for clients that do not anticipate storing much data in the DFS. Data utility company accounting may charge for rewrite processes only for service and data transfer initiated by the client, and not for transfers caused by internal operation of the DFS (such as adjusting location of data storage as data farms come online and go offline).

Alternatively, a Primary Source Data Client may be billed on a flat fee schedule (e.g., a monthly fee), or a hybrid billing model (e.g., a flat fee up to a predetermined limit, with a per-megabyte fee above the limit). Billing may also be divided into separate fees for transmission and for storage. Client will be allowed a certain amount of monthly data transfer (writes and rewrites) along with a lease of specific amounts of data storage. Different tiered memberships may be available to meet the needs of subscription-based clients. Tiers may be structured based on factors such as storage capacity used, bytes of data transfer used, speed of data access (latency or communication speed), the amount of times backups are replicated, to what regions replications are sent to, and so forth. Client-initiated rewrites or stored data would only use the allotted amount of data transfer limits associated with the client's specific subscription tier. Exceeding these limits would result charges based on overage rates at premium costs.

A Primary Source Data Client may also be billed based on any number of factors or optional value-added services, such as the degree of replication or redundancy, regionalization (i.e., dispersal) of their data, strength of encryption, etc. For example, a Primary Source Data Client preferring a higher degree of data security may choose to have their data replicated on a greater number of data farms 104, with a concomitant greater billing.

Alternatively, a Primary Source Data Client may prefer to use the DFS only for emergency backup purposes, in exchange for appropriate billing that recognizes the infrequent but critical instances that the client would be retrieving stored data. Greater latency of data retrieval for such service may be tolerated, because of the infrequent nature of such access.

A Primary Source Data Client may continue to use other storage not associated with the DFS without charge, e.g., local storage, remote storage (e.g., LAN-based storage, other cloud-based storage not associated with the DFS of the present invention, etc.), local backups, and so forth.

In some embodiments in accordance with the present invention, the Data Utility Company may provide one or more temporary data storage units in server 106 in order to store incoming client data for storage and backups. The Data Utility may then replicate, encrypt, and transmit the data to multiple data farms 104.

Over time, additional individual data farms 104-n may be added to the DFS, or some data farms 104-n may become inactive due to aforementioned disruptions to the data farm 104-n and/or its communication link to WAN 101. In some embodiments in accordance with the present invention, when a new data farm 104-n is added to the DFS, its addition to the DFS may be recorded by the storage network module 110. Thereafter, data farm 104-n and storage network module 110 may exchange periodic ping, heartbeat or monitoring signals such that storage network module 110 is aware that data farm 104-n is operating normally. If storage network module 110 fails to receive an expected ping response, heartbeat message or monitoring message from data farm 104-n, storage network module 110 may infer that data farm 104-n is offline and modify internal routing tables such that new data to be stored is not assigned to data farm 104-n. The responsible data farmer may be notified of the status of their data farm 104-n and/or be penalized.

Data farm 104-n may be periodically pinged thereafter to determine if data farm 104-n has come back on-line. If so, and after waiting for an optional waiting period in case intermittent problems persist, the DFS may again utilize data farm 104-n as usual.

In some embodiments in accordance with the present invention, if a Primary Source Data Client has not accessed some of their data for more than a predetermined period of time, the Primary Source Data Client may request that their data be rewritten in the DFS. The rewritten data (or portions thereof) may be written to the same data farm(s) 104-n or to different data farm(s) 104-n. By this method, operation of the DFS may also help guard against data becoming inaccessible when stored in an offline data farm 104-n. If the data is rewritten to the same data farm 104-n, then new data is not being written to the data farm 104-n, potentially providing a cost savings to a user who is being billed based upon the amount of data transferred. The data farmer may continue to be paid for the transfer and storage of the information. If storage exceeds limits specified in a lease agreement, the data farmer may be compensated based on new lease agreements with the Primary Source Data Client.

Billing agreements between a Primary Source Data Client and a data farmer may further depend upon levels of service and a spending budget available to the Primary Source Data Client. For example, the level of service could be based on which regions the Client's information will be stored in duplication. For example, storm or disaster prone areas would fall in a lower priced agreement with a higher risk factor. Locations with faster internet infrastructures and/or lower disaster rates would be a higher priced agreement. Billing may also depend upon the type of data farm used, latency of the storage used, and so forth. For example, usage of data farms housed in residences may be billed at a different rate than usage of data farms housed in commercial buildings. The sensitivity of the Client's information and frequency of retrieval may be used to determine the rate charged.

Further embodiments of operating the DFS may include paying a bonus to a data farmer who stores and is able to successfully retrieve a backup that is requested by a Primary Source Data Client. This will tend to encourage participation and maintenance (if any) by data farmers, e.g., by diligently tending to the electrical and data communication needs (if any) and security of their data farms.

Embodiments in accordance with the present invention may provide that the Data Utility will determine which data farmers from among potentially multiple farmers that are qualified under the Primary Source Data Client's request (e.g., geographic location, business/residential data farm, storage media latency, etc.) will provide the backup data. The Data Utility may consider one or more factors such as the present storage and communication capacity of qualified data farmers, which in turn may depend upon other factors such as the current internet traffic in that region, locality and site bandwidth traffic, and so forth. The Data Utility may choose one or more data farmers based on a preferred combination of such present factors.

Embodiments in accordance with the present invention may provide a choice of different service levels to data farmers, in order for the data farmer to select a level of service for providing data storage services. Differing levels of data storage services may affect decisions by data farmers regarding types of storage assets to deploy and a location on or within their property the data storage assets are placed. For example, some data farmers may allocate 80% of their data storage capacity to a first type of storage asset and/or a first location of the storage assets in exchange for a service providing a guaranteed rate of return, another 15% of their data storage capacity to a second type of storage asset and/or a second location of the storage assets in exchange for a service providing payment at a higher rate only for storage space that is actually utilized by a Primary Source Data Client, and the final 5% of their data storage capacity may be allocated to a third type of storage asset and/or a third location of the storage assets in exchange for a service providing emergency backups and over-limit data usages by Primary Source Data Clients. Such emergency backup and/or over-limit data usages are not as likely but will generate proportionally more revenue if they are utilized. This allocation may be changed periodically by the data farmer, subject to the capacity needs of the DFS and the Data Utility.

Embodiments of the present invention may provide disaster recovery services to user 102-m at computing node 152-m. For example, user 102-m may notify the administrative module 112 that some or all of their data backed up in the distributed file system needs to be restored. An exemplary cause may include if user 102-m has suffered a failure of primary storage elements associated with computing node 152-m. In this situation, a disaster recovery service in accordance with an embodiment of the present invention may include providing an ability to reassemble the data of user 102-m from various portions of the client's data that are backed up within the DFS. The restored data may be supplied to the client, or may be temporarily stored in another location (e.g., in a memory within server 106), or be made accessible to the client in its distributed state for the purpose of distributed computing provided by cloud computing services.

Embodiments of the present invention include a system having one or more processing units coupled to one or more memories. The one or more memories may be configured to store software that, when executed by the one or more processing unit, allows practicing embodiments of the invention, at least by use of processes described herein, including at least in the Figures and related text.

The disclosed methods may be readily implemented in software, such as by using object or object-oriented software development environments that provide portable source code that can be used on a variety of computer or workstation platforms. Alternatively, the disclosed system may be implemented partially or fully in hardware, such as by using standard logic circuits or VLSI design. Whether software or hardware may be used to implement the systems in accordance with various embodiments of the present invention may be dependent on various considerations, such as the speed or efficiency requirements of the system, the particular function, and the particular software or hardware systems being utilized.

While the foregoing is directed to embodiments of the present invention, other and further embodiments of the present invention may be devised without departing from the basic scope thereof. It is understood that various embodiments described herein may be utilized in combination with any other embodiment described, without departing from the scope contained herein. Further, the foregoing description is not intended to be exhaustive or to limit the invention to the precise form disclosed. Modifications and variations are possible in light of the above teachings or may be acquired from practice of the invention. Certain exemplary embodiments may be identified by use of an open-ended list that includes wording to indicate that the list items are representative of the embodiments and that the list is not intended to represent a closed list exclusive of further embodiments. Such wording may include "e.g.," "etc.," "such as," "for example," "and so forth," "and the like," etc., and other wording as will be apparent from the surrounding context.

No element, act, or instruction used in the description of the present application should be construed as critical or essential to the invention unless explicitly described as such. Also, as used herein, the article "a" is intended to include one or more items. Where only one item is intended, the term "one" or similar language is used. Further, the terms "any of" followed by a listing of a plurality of items and/or a plurality of categories of items, as used herein, are intended to include "any of," "any combination of," "any multiple of," and/or "any combination of multiples of" the items and/or the categories of items, individually or in conjunction with other items and/or other categories of items.

Moreover, the claims should not be read as limited to the described order or elements unless stated to that effect. In addition, use of the term "means" in any claim is intended to invoke 35 U.S.C. §112, ¶ 6, and any claim without the word "means" is not so intended.

The invention might include, relate to, and/or be defined by, the following aspects:
1. A building support with a concealed electronic component for a structure, comprising:
   a rigid support member;
   a mounting attachment affixed to the rigid support member, the mounting attachment adapted to support the concealed electronic component; and
   a transceiver coupled to the concealed electronic component, the transceiver adapted to support an external communication link.
2. The building support of aspect 1, wherein the building support comprises a wall stud.
3. The building support of aspect 1, wherein the building support comprises a floor joist.
4. The building support of aspect 1, wherein the building support comprises a heating and cooling duct.
5. The building support of aspect 1, wherein the building support comprises a concrete slab, the concrete slab comprising a void adapted to enclose the concealed electronic component.
6. The building support of aspect 1, wherein the building support is positioned in an area above a false ceiling.
7. The building support of aspect 1, wherein the building support is positioned in an area below a raised floorboard.
8. The building support of aspect 1, wherein the building support comprises an item selected from a group consisting of a hollow core door, a rooftop, an outdoor structure, an element of a garage, an element of a shed.
9. A backing material to support an electronic component concealed within a building structural element, wherein the building structural element comprises one or more rigid building support members, the backing material comprising:
   a substrate;
   a structure attachment along at least one surface of the substrate, the attachment adapted to attach the substrate to a rigid building support member; and
   one or more electronic component attachments disposed on a major surface of the rigid substrate.
10. The backing material of aspect 9, wherein the substrate comprises a flexible substrate, wherein the substrate when draped between adjacent rigid building support members, is adapted to substantially maintain a predetermined relative physical configuration among a plurality of electronic components coupled to the one or more electronic component attachments.
11. The backing material of aspect 9, wherein the substrate comprises a substantially rigid substrate.
12. The backing material of aspect 9, wherein the rigid building support member comprises a wall stud.
13. The backing material of aspect 9, wherein the substrate is adapted to be supported by one rigid building support member.
14. The backing material of aspect 9, wherein the substrate may be coupled to a second substantially rigid substrate.
15. The backing material of aspect 9, wherein the electronic component comprises a data storage device.
16. The backing material of aspect 10, wherein the plurality of electronic components comprise a data farm.
17. The backing material of aspect 16, wherein the plurality of electronic components further comprise a transceiver adapted to support an external communication link.

## Claims

1. A system for distributed file storage, the system comprising: a plurality of data farms, each data farm including: a data storage module; a local control module comprising a data protection module; and a communication interface between said data farm and a wide-area network; an interface to one or more remote data applications; and an administrative module configured to record a quantity of data received or transmitted by the communication interface of the data farm.

2. The system of claim 1, wherein the administrative module is configured to record a quantity of data received or transmitted by the interface to one or more remote data servers.

3. The system of claim 1 or 2, comprising:
a storage network module configured to determine an association between a data farm and the one or more remote data servers.

4. The system of claim 1, 2 or 3 wherein the local control module is configured to determine an association between data stored in a respective data farm and the one or more remote data servers.

5. The system of any preceding claim, wherein substantially each data farm is in an untrusted data relationship to other data farms.

6. The system of any preceding claim, further comprising a module configured to monitor a state of health of said data farm.

7. The system of any preceding claim, wherein a physical location of the remote data server is not known to the data farm.

8. The system of claim 1, wherein at least some of the structures have a primary purpose unrelated to data storage.

9. A method of distributed file storage, the method comprising: providing a plurality of data farms; accepting data from a remote data application; selecting a data farm from among the plurality of data farms in which to store the data; and storing the data in the selected data farm.

10. The method of claim 9, comprising the steps of:
recording a quantity of data transferred to the selected data farm; and
providing a credit to an owner of the selected data farm based upon the quantity of data transferred.

11. The method of claim 9 or 10, comprising the steps of:
recording a quantity of data transferred from the remote data server; and
charging a fee to the remote data server based upon the quantity of data transferred.

12. The method of claim 9, 10 or 11, wherein the step of selecting a data farm comprises the step of using a Hadoop process.

13. The method of any one of claims 9-12, wherein a physical location of the remote data server is not known to the data farm.

14. The method of any one of claims 9-13, wherein at least some of the structures have a primary purpose unrelated to data storage.
